# EUROPEAN PATENT SPECIFICATION

(11) **EP 3 162 917 B1**
(45) Date of publication and mention of the grant of the patent: **06.12.2023**
(21) Application number: 16195817.8
(22) Date of filing: 26.10.2016
(51) Int. Cl.: C23C 28/02, B23P 5/00, B23P 6/00, C23C 4/073, F01D 5/00, C23C 4/10, C23C 4/12, C23C 28/00, F01D 5/28

(54) **METHODS OF REPAIRING A THERMAL BARRIER COATING OF A GAS TURBINE COMPONENT AND THE RESULTING COMPONENTS**
VERFAHREN ZUR REPARATUR DER WÄRMEDÄMMSCHICHT EINER GASTURBINENKOMPONENTE UND RESULTIERENDE KOMPONENTEN
PROCÉDÉS DE RÉPARATION D'UN REVÊTEMENT BARRIÈRE THERMIQUE D'UN COMPOSANT DE TURBINE À GAZ ET COMPOSANTS AINSI OBTENUS

(30) Priority: 28.10.2015 US 201514925288
(43) Date of publication of application: 03.05.2017
(73) Proprietor: General Electric Company, Schenectady, NY 12345 (US)
(72) Inventor: NAGARAJ, Bangalore Aswatha, Cincinnati, OH 45215 (US)
(74) Representative: Openshaw & Co.

(56) References cited:
- EP-A1- 2 743 369
- EP-A2- 1 598 439
- EP-A2- 1 939 317
- WO-A1-2013/037391
- CN-A- 104 674 217
- US-A1- 2004 256 504
- US-A1- 2009 162 692
- US-A1- 2014 193 664
- Brian Gleeson: "Alloy degradation under oxidizing-sulfidizing conditions at elevated temperatures", Materials Research, vol. 7, no. 1 1 March 2004 (2004-03-01), XP002767547, ISSN: 1980-5373 Retrieved from the Internet: URL:http://dx.doi.org/10.1590/S1516-143920 04000100010 [retrieved on 2017-02-23]

## Description

### FIELD OF THE INVENTION

This invention relates to coatings capable of use on components exposed to high temperatures, such as the hostile thermal environment of a gas turbine engine. More particularly, this invention is directed to a thermal barrier coating (TBC) that exhibits resistance to thermal cycling and infiltration by contaminants, for example, of types that may be present in the operating environment of a gas turbine engine.

### BACKGROUND OF THE INVENTION

The use of thermal barrier coatings (TBCs) on components such as combustors, high pressure turbine (HPT) blades, vanes and shrouds helps such components to survive higher operating temperatures, increases component durability, and improves engine reliability. TBCs are typically formed of a ceramic material and deposited on an environmentally-protective bond coat to form what is termed a TBC system. Bond coat materials widely used in TBC systems include oxidation-resistant overlay coatings such as MCrAlX (where M is iron, cobalt and/or nickel, and X is yttrium or another rare earth element), and diffusion coatings such as diffusion aluminides that contain aluminum intermetallics. Bond coat materials are typically selected to be capable of forming a continuous and adherent oxide scale on their surface to promote the adhesion of the ceramic coat to the bond coat. The oxide scale can be formed by subjecting the bond coat to an oxidizing environment, such that the scale is sometimes referred to as a thermally-grown oxide (TGO).

Under service conditions, hot section engine components protected by a TBC system can be susceptible to various modes of damage, including erosion, oxidation and corrosion from exposure to the gaseous products of combustion, foreign object damage (FOD), and attack from environmental contaminants. The source of environmental contaminants is ambient air, which is drawn in by the engine for cooling and combustion. The type of environmental contaminants in ambient air will vary from location to location, but can be of a concern to aircraft as their purpose is to move from location to location. Environmental contaminants that can be present in the air include sand, dirt, volcanic ash, sulfur in the form of sulfur dioxide, fly ash, particles of cement, runway dust, and other pollutants that may be expelled into the atmosphere, such as metallic particulates, for example, magnesium, calcium, aluminum, silicon, chromium, nickel, iron, barium, titanium, alkali metals and compounds thereof, including oxides, carbonates, phosphates, salts and mixtures thereof. These environmental contaminants are in addition to the corrosive and oxidative contaminants that result from the combustion of fuel. However, all of these contaminants can adhere to the surfaces of the hot section components, including those that are protected with a TBC system.

Some of these contaminants may result in TBC loss over the life of the components. For example, particulates of calcia (CaO), magnesia (MgO), alumina (aluminum oxide; Al₂O₃) and silica (silicon dioxide; SiO₂) are often present in environments containing fine sand and/or dust. When present together at elevated temperatures, calcia, magnesia, alumina and silica can form a eutectic compound referred to herein as CMAS. CMAS has a relatively low melting temperature, such that during turbine operation the CMAS that deposits on a component surface can melt, particularly if surface temperatures exceed about 2240° F. (1227° C.). Molten CMAS is capable of infiltrating the porosity within TBCs. For example, CMAS is capable of infiltrating into TBCs having columnar structures, dense vertically-cracked TBCs, and the horizontal splat boundaries of TBCs deposited by thermal and plasma spraying. The molten CMAS resolidifies within cooler subsurface regions of the TBC, where it interferes with the compliance of the TBC and can lead to spallation and degradation of the TBC, particularly during thermal cycling as a result of interfering with the ability of the TBC to expand and contract. In addition to loss of compliance, deleterious chemical reactions with yttria and zirconia within the TBC, as well as with the thermally-grown oxide at the bond coat/TBC interface, can occur and cause degradation of the TBC system. Once the passive thermal barrier protection provided by the TBC has been lost, continued operation of the engine can lead to oxidation of the base metal beneath the TBC system.

In view of the above, it can be appreciated that it would be desirable if systems and methods were available that are capable of promoting the resistance of components to contaminants, such as CMAS, and particularly gas turbine engine components that operate at temperatures above the melting temperatures of contaminants. Additionally, there is the inevitable requirement to repair such coatings under certain circumstances, particularly high temperature components of gas turbine engines that are subjected to intense thermal cycling.

Patent documents EP 2743369 A1, EP1939317 A2 and US 2009/162692 A1 disclose turbine engine components with thermal barrier coatings thereon and define bond coating systems to improve the thermal and environmental resistance of the coating. Patent documents US2014/193664 A1, EP 1598439 A2 and US 2004/256504 A1 describe turbine components with repaired areas and methods therefor. EP 1598439 A2 also discloses a turbine component with a bond coating with controlled porosity and a ceramic coating thereon to enlarge the service life of the component.

CN 104674217 A also discloses a turbine engine component with a double layer bond coating and an outer ceramic layer wherein the inner bond coating is made of a CoNiCrAlY alloy and the outer bond coating is a Co-free alloy.

### BRIEF DESCRIPTION OF THE INVENTION

Aspects and advantages of the invention will be set forth in part in the following description.

Embodiments of the invention are defined in the dependent claims. Turbine engine components are generally provided that have a repaired thermal barrier coating, along with their methods of formation and repair.

The turbine engine component according to claim 1 includes a substrate defining a surface; a thermal barrier coating on a first portion of the surface of the substrate; a repaired thermal barrier coating on a second portion of the surface of the substrate; and a ceramic coat on the outer bond coat. The thermal barrier coating includes an inner bonding layer and a first ceramic layer, with the inner bonding layer being positioned between the substrate and the first ceramic layer. The repaired thermal barrier coating generally includes an inner bond coat on the surface of the substrate and an outer bond coat on the inner bond coat. The inner bond coat is formed from a cobalt-containing material, while the outer bond coat is substantially free from cobalt.

The turbine engine component has a repaired thermal barrier coating and includes a substrate defining a surface; an inner bonding layer on the surface of the substrate; an inner bond coat on the inner bonding layer; an outer bond coat on the inner bond coat; and a ceramic coat on the outer bond coat. The inner bond coat is formed from a cobalt-containing material, while the outer bond coat is substantially free from cobalt.

Methods are generally provided for repairing a thermal barrier coating on a turbine engine component. A disclosed method according to claim 5 includes removing any ceramic coating from an area of a surface of a substrate; forming an inner bond coat over the area of the surface of the substrate; forming an outer bond coat over the inner bond coat; and forming a ceramic coat on the outer bond coat. The inner bond coat is formed from a cobalt-containing material, while the outer bond coat is substantially free from cobalt.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

A full and enabling disclosure of the present invention, including the best mode thereof, directed to one of ordinary skill in the art, is set forth in the specification, which makes reference to the appended Figs., in which:
FIG. 1 is a schematic cross-sectional view of an exemplary gas turbine engine according to various embodiments of the present subject matter;
FIG. 2 is a perspective, cross-sectional view of a combustor assembly in accordance with an exemplary embodiment of the present disclosure;
FIG. 3 is a close-up, cross-sectional view of an exemplary two layer bond coat TBC on a substrate;
FIG. 4 is a close-up, cross-sectional view of an exemplary three layer bond coat TBC on a substrate;
FIG. 5 shows a coated substrate having a damaged TBC;
FIG. 6A shows the coated substrate of FIG. 5 after removing the damaged TBC to expose the entire surface of the substrate;
FIG. 6B shows the coated substrate of FIG. 5 after removing the damaged TBC while leaving a portion of the bond layer on the surface of the substrate;
FIG. 7 shows the coated substrate of FIG. 6B after performing the repair method according to one embodiment;
FIG. 8 shows a coated substrate having a TBC on its surface with localized damage on a portion thereof;
FIG. 9A shows the coated substrate of FIG. 8 after locally removing the damaged TBC to expose the portion of the surface of the substrate underlying the damaged area of the TBC;
FIG. 9B shows the coated substrate of FIG. 8 after locally removing the damaged TBC while leaving a portion of the bond layer underlying the damaged area of the TBC;
FIG. 10A shows the coated substrate of FIG. 9A after performing the repair method according to one embodiment; and
FIG. 10B shows the coated substrate of FIG. 9B after performing the repair method according to one embodiment.

Repeat use of reference characters in the present specification and drawings is intended to represent the same or analogous features or elements of the present invention.

### DETAILED DESCRIPTION OF THE INVENTION

Reference now will be made in detail to embodiments of the invention, one or more examples of which are illustrated in the drawings. Each example is provided by way of explanation of the invention, not limitation of the invention.

In the present invention, when a layer is being described as "on" or "over" another layer or substrate, it is to be understood that the layers can either be directly contacting each other or have another layer or feature between the layers, unless expressly stated to the contrary. Thus, these terms are simply describing the relative position of the layers to each other and do not necessarily mean "on top of" since the relative position above or below depends upon the orientation of the device to the viewer.

As used herein, the terms "first", "second", and "third" may be used interchangeably to distinguish one component from another and are not intended to signify location or importance of the individual components.

The terms "upstream" and "downstream" refer to the relative direction with respect to fluid flow in a fluid pathway. For example, "upstream" refers to the direction from which the fluid flows, and "downstream" refers to the direction to which the fluid flows.

Turbine engine components are generally provided that include a two-layer (or more) bond coat system to form a thermal barrier coating (TBC) on a substrate. As such, the present invention is generally applicable to metal components that are protected from a thermally hostile environment by a thermal barrier coating (TBC) system. Notable examples of such components include the high and low pressure turbine nozzles (vanes), shrouds, combustor liners, combustor domes and heat shields, transition pieces, turbine frame and augmentor hardware of gas turbine engines. While this disclosure is particularly applicable to turbine engine components, the teachings of this disclosure are generally applicable to any component on which a thermal barrier may be used to thermally insulate the component from its environment.

In particular, a two-layer bond coat system is generally provided with an inner bond coat having chemistry particularly suitable for corrosion, cracking & oxidation resistance while an outer bond coat has chemistry and structure for TBC adhesion thereto. That is, the inner bond coat provides a dense microstructure and chemistry for oxidation, corrosion, and cracking resistance, with the outer bond coat providing the necessary surface roughness for the TBC adherence. As such, the presently provided bond coat system provides a higher temperature capability compared to the baseline bond coat formed from a single layer.

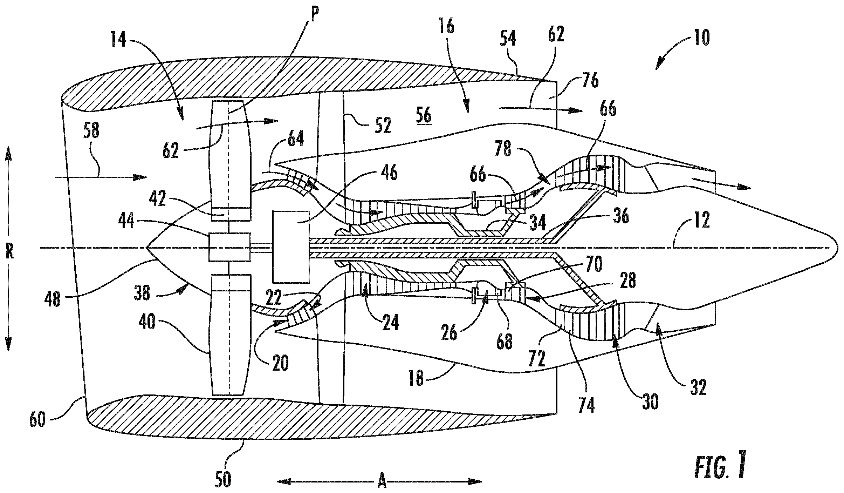

Referring now to the drawings, FIG. 1 is a schematic cross-sectional view of a gas turbine engine in accordance with an exemplary embodiment of the present disclosure. More particularly, for the embodiment of FIG. 1, the gas turbine engine is a high-bypass turbofan jet engine 10, referred to herein as "turbofan engine 10." As shown in FIG. 1, the turbofan engine 10 defines an axial direction A (extending parallel to a longitudinal centerline 12 provided for reference) and a radial direction R. In general, the turbofan 10 includes a fan section 14 and a core turbine engine 16 disposed downstream from the fan section 14.

The exemplary core turbine engine 16 depicted generally includes a substantially tubular outer casing 18 that defines an annular inlet 20. The outer casing 18 encases, in serial flow relationship, a compressor section including a booster or low pressure (LP) compressor 22 and a high pressure (HP) compressor 24; a combustion section 26; a turbine section including a high pressure (HP) turbine 28 and a low pressure (LP) turbine 30; and a jet exhaust nozzle section 32. A high pressure (HP) shaft or spool 34 drivingly connects the HP turbine 28 to the HP compressor 24. A low pressure (LP) shaft or spool 36 drivingly connects the LP turbine 30 to the LP compressor 22.

For the embodiment depicted, the fan section 14 includes a variable pitch fan 38 having a plurality of fan blades 40 coupled to a disk 42 in a spaced apart manner. As depicted, the fan blades 40 extend outwardly from disk 42 generally along the radial direction R. Each fan blade 40 is rotatable relative to the disk 42 about a pitch axis P by virtue of the fan blades 40 being operatively coupled to a suitable actuation member 44 configured to collectively vary the pitch of the fan blades 40 in unison. The fan blades 40, disk 42, and actuation member 44 are together rotatable about the longitudinal axis 12 by LP shaft 36 across an optional power gear box 46. The power gear box 46 includes a plurality of gears for stepping down the rotational speed of the LP shaft 36 to a more efficient rotational fan speed.

Referring still to the exemplary embodiment of FIG. 1, the disk 42 is covered by rotatable front nacelle 48 aerodynamically contoured to promote an airflow through the plurality of fan blades 40. Additionally, the exemplary fan section 14 includes an annular fan casing or outer nacelle 50 that circumferentially surrounds the fan 38 and/or at least a portion of the core turbine engine 16. It should be appreciated that the nacelle 50 may be configured to be supported relative to the core turbine engine 16 by a plurality of circumferentially-spaced outlet guide vanes 52. Moreover, a downstream section 54 of the nacelle 50 may extend over an outer portion of the core turbine engine 16 so as to define a bypass airflow passage 56 therebetween.

During operation of the turbofan engine 10, a volume of air 58 enters the turbofan 10 through an associated inlet 60 of the nacelle 50 and/or fan section 14. As the volume of air 58 passes across the fan blades 40, a first portion of the air 58 as indicated by arrows 62 is directed or routed into the bypass airflow passage 56 and a second portion of the air 58 as indicated by arrow 64 is directed or routed into the LP compressor 22. The ratio between the first portion of air 62 and the second portion of air 64 is commonly known as a bypass ratio. The pressure of the second portion of air 64 is then increased as it is routed through the high pressure (HP) compressor 24 and into the combustion section 26, where it is mixed with fuel and burned to provide combustion gases 66.

The combustion gases 66 are routed through the HP turbine 28 where a portion of thermal and/or kinetic energy from the combustion gases 66 is extracted via sequential stages of HP turbine stator vanes 68 that are coupled to the outer casing 18 and HP turbine rotor blades 70 that are coupled to the HP shaft or spool 34, thus causing the HP shaft or spool 34 to rotate, thereby supporting operation of the HP compressor 24. The combustion gases 66 are then routed through the LP turbine 30 where a second portion of thermal and kinetic energy is extracted from the combustion gases 66 via sequential stages of LP turbine stator vanes 72 that are coupled to the outer casing 18 and LP turbine rotor blades 74 that are coupled to the LP shaft or spool 36, thus causing the LP shaft or spool 36 to rotate, thereby supporting operation of the LP compressor 22 and/or rotation of the fan 38.

The combustion gases 66 are subsequently routed through the jet exhaust nozzle section 32 of the core turbine engine 16 to provide propulsive thrust. Simultaneously, the pressure of the first portion of air 62 is substantially increased as the first portion of air 62 is routed through the bypass airflow passage 56 before it is exhausted from a fan nozzle exhaust section 76 of the turbofan 10, also providing propulsive thrust. The HP turbine 28, the LP turbine 30, and the jet exhaust nozzle section 32 at least partially define a hot gas path 78 for routing the combustion gases 66 through the core turbine engine 16.

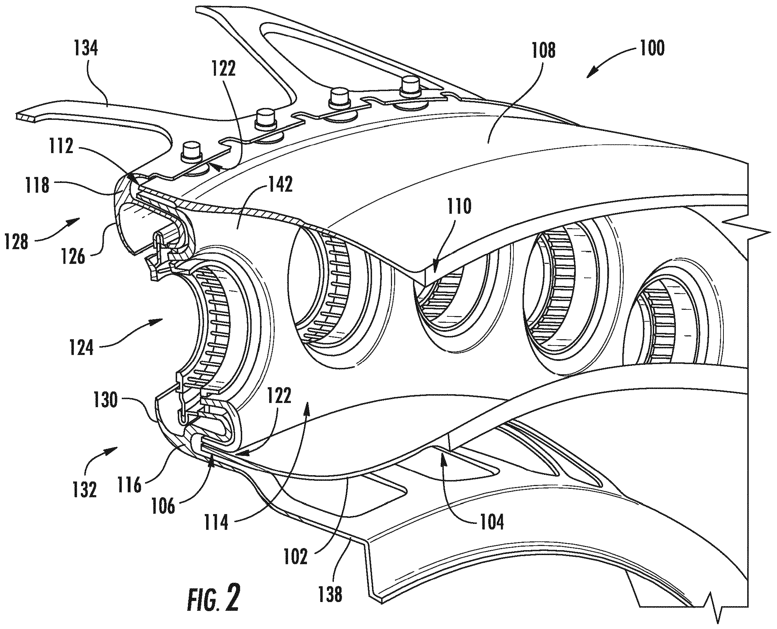

Referring now to FIG. 2, close-up cross-sectional views are provided of the combustion section 26 of the exemplary turbofan engine 10 of FIG. 1. More particularly, FIG. 2 provides a perspective, cross-sectional view of a combustor assembly 100, which may be positioned in the combustion section 26 of the exemplary turbofan engine 10 of FIG. 1, in accordance with an exemplary embodiment of the present disclosure. Notably, FIG. 2 provides a perspective, cross-sectional view of the combustor assembly 100 having an outer combustor casing removed for clarity.

As shown, the combustor assembly 100 generally includes an inner liner 102 extending between an aft end 104 and a forward end 106 generally along the axial direction A, as well as an outer liner 108 also extending between and aft end 110 and a forward end 112 generally along the axial direction A. The inner and outer liners 102, 108 together at least partially define a combustion chamber 114 therebetween. The inner and outer liners 102, 108 are each attached to an annular dome. More particularly, the combustor assembly 100 includes an inner annular dome 116 attached to the forward end 106 of the inner liner 102 and an outer annular dome 118 attached to the forward end 112 of the outer liner 108. Although the inner and outer annular domes 116, 118 are shown each including an enclosed surface defining a slot 122 for receipt of the forward ends 106, 112 of the respective inner and outer liners 102, 108, any suitable attachment scheme can be utilized to attach the liners to the respective domes. Also, although the exemplary combustor assembly 100 is shown including an inner and an outer annular dome, it is to be understood that presently disclosed coatings and coating systems also applies to single dome constructions and multi-dome constructions (e.g., 3 domes, etc.).

The combustor assembly 100 further includes a plurality of fuel air mixers 124 spaced along a circumferential direction within the outer dome 118. More particularly, the plurality of fuel air mixers 124 are disposed between the outer dome 118 and the inner dome 116 along the radial direction R. Compressed air from the compressor section of the turbofan engine 10 flows into or through the fuel air mixers 124, where the compressed air is mixed with fuel and ignited to create the combustion gases 66 within the combustion chamber 114. The inner and outer domes 116, 118 are configured to assist in providing such a flow of compressed air from the compressor section into or through the fuel air mixers 126. For example, the outer dome 118 includes an outer cowl 126 at a forward end 128 and the inner dome 116 similarly includes an inner cowl 130 at a forward end 132. The outer cowl 126 and inner cowl 130 may assist in directing the flow of compressed air from the compressor section 26 into or through one or more of the fuel air mixers.

Moreover, the inner and outer domes 116, 118 each include attachment portions configured to assist in mounting the combustor assembly 100 within the turbofan engine 10. For example, the outer dome 118 includes an attachment extension 134 configured to be mounted to an outer combustor casing (not shown) and the inner dome 116 includes a similar attachment extension 138 configured to attach to an annular support member (not shown) within the turbofan engine 10. In certain exemplary embodiments, the inner dome 116 may be formed integrally as a single annular component, and similarly, the outer dome 118 may also be formed integrally as a single annular component. It should be appreciated, however, that in other exemplary embodiments, the inner dome 116 and/or the outer dome 118 may alternatively be formed by one or more components joined in any suitable manner. For example, with reference to the outer dome 118, in certain exemplary embodiments, the outer cowl 126 may be formed separately from the outer dome 118 and attached to the forward end 128 of the outer dome 118 using, e.g., a welding process. Similarly, the attachment extension 134 may also be formed separately from the outer dome 118 and attached to the forward end 128 of the outer dome 118 using, e.g., a welding process. Additionally, or alternatively, the inner dome 116 may have a similar configuration.

Referring still to FIG. 2, the exemplary combustor assembly 100 further includes a plurality of heat shields 142 positioned around each fuel air mixer 124, arrange circumferentially. The heat shields 142, for the embodiment depicted, are attached to and extend between the outer dome 118 and the inner dome 116. The heat shields 142 are configured to protect certain components of the turbofan engine 10 from the relatively extreme temperatures of the combustion chamber 114.

In certain embodiments, the inner liner 102 and outer liner 108 are each comprised of a metal, such as a nickel-based superalloy or cobalt-based superalloy. In alternative embodiments, the inner liner 102 and outer liner 108 are each comprised of a ceramic matrix composite (CMC) material, which is a non-metallic material having high temperature capability. Exemplary CMC materials utilized for such liners 102, 108 may include silicon carbide, silicon, silica or alumina matrix materials and combinations thereof. Ceramic fibers may be embedded within the matrix, such as oxidation stable reinforcing fibers including monofilaments like sapphire and silicon carbide (e.g., Textron's SCS-6), as well as rovings and yarn including silicon carbide (e.g., Nippon Carbon's NICALON^{®}, Ube Industries' TYRANNO^{®}, and Dow Corning's SYLRAMIC^{®}), alumina silicates (e.g., Nextel's 440 and 480), and chopped whiskers and fibers (e.g., Nextel's 440 and SAFFIL^{®}), and optionally ceramic particles (e.g., oxides of Si, Al, Zr, Y and combinations thereof) and inorganic fillers (e.g., pyrophyllite, wollastonite, mica, talc, kyanite and montmorillonite).

The inner dome 116, outer dome 118, including the inner cowl 130 and outer cowl 126, respectively, and the heat shields 142 may be formed of a metal, such as a nickel-based superalloy or cobalt-based superalloy.

As stated above, each of these components are exposed to harsh conditions of relatively high temperatures and/or pressures. As such, a thermal barrier coating is present at least on the exposed surfaces of any metal component.

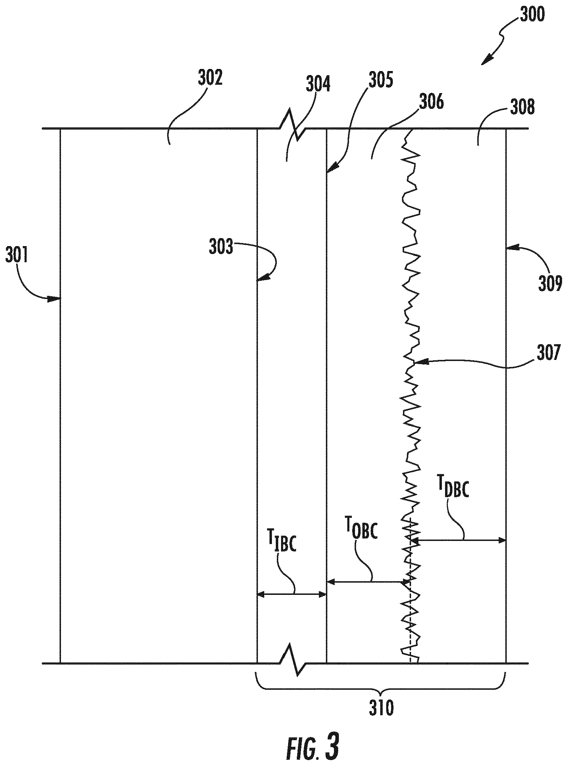

FIG. 3 shows a cross-sectional view of an exemplary turbine engine component 300 having a TBC coating system 310 on a substrate 302. Generally, the substrate 302 defines a coated surface 303 (i.e., a first surface 303 having a coating thereon) that is referred to as the "hot" side since it is the surface of the component 300 that is exposed to the combustion gasses within the engine. Also, the component has a second surface 301 that is positioned opposite of the coated surface 303 on the "cold" side of the component 300. In one embodiment, the substrate 302 is formed of any operable material. For example, the substrate 302 may be formed of any of a variety of metals or metal alloys, including those based on nickel, cobalt and/or iron alloys or superalloys. In one embodiment, substrate 302 is made of a nickel-base alloy, and in another embodiment substrate 302 is made of a nickel-base superalloy. A nickel-base superalloy may be strengthened by the precipitation of gamma prime or a related phase. In one example, the nickel-base superalloy has a composition, in weight percent, of from about 4 to about 20 percent cobalt, from about 1 to about 10 percent chromium, from about 5 to about 7 percent aluminum, from about 0 to about 2 percent molybdenum, from about 3 to about 8 percent tungsten, from about 4 to about 12 percent tantalum, from about 0 to about 2 percent titanium, from about 0 to about 8 percent rhenium, from about 0 to about 6 percent ruthenium, from about 0 to about 1 percent niobium, from about 0 to about 0.1 percent carbon, from about 0 to about 0.01 percent boron, from about 0 to about 0.1 percent yttrium, from about 0 to about 1.5 percent hafnium, balance nickel and incidental impurities. For example, a suitable nickel-base superalloy is available by the trade name Rene N5, which has a nominal composition by weight of 7.5% cobalt, 7% chromium, 1.5% molybdenum, 6.5% tantalum, 6.2% aluminum, 5% tungsten, 3% rhenium, 0.15% hafnium, 0.004% boron, and 0.05% carbon, and the balance nickel and minor impurities.

In the embodiment shown, the TBC coating system 310 includes an inner bond coat 304 on the first surface 303 of the substrate 302, an outer bond coat 306 on the surface 305 of the inner bond coat 304, and a ceramic coat 308 on a texturized surface 307 of the outer bond coat 307. As such, the ceramic coat 308 defines an exterior surface 309 that is exposed.

As stated, the inner bond coat 304 has a dense microstructure and chemistry particularly suitable for oxidation, corrosion, and cracking resistance. On the other hand, the outer bond coat 306 has chemistry and structure for TBC adhesion thereto as well as providing a surface roughness for the TBC adherence thereon. Thus, the inner bond coat 304 is generally a dense layer compared to the outer bond coat 206. That is, the inner bond coat 304 has a porosity that is less than the porosity of the outer bond coat 206. The inner bond coat 304 has a porosity that is 0.5% to 5% while the outer bond coat 306 has a porosity that is 5% to 25 %.

The inner bond coat 304 includes a cobalt-containing material, a CoNiCrAlY alloy. Without wishing to be bound by any particular theory, it is believed that the presence of cobalt in the inner bond coat 304, particularly when combined with a relatively dense construction (e.g., a porosity of less than 5%), provides increased resistance to sulfur diffusion through the inner bond coat 304. The inner bond coat 304 includes a CoNiCrAlY alloy having a composition of (by weight) about 31.0% to about 33.5% nickel, about 21.0% to about 23.0% chromium, about 9.5% to about 10.5% aluminum, 0.05% to about 0.50% yttrium, 0% to about 0.01% phosphorous, 0% to about 0.01% nitrogen, 0% to about 0.040% oxygen, and the balance cobalt.

The inner bond coat 304 is formed via high velocity oxy-fuel coating spraying a plurality of particles onto the surface 303 of the substrate 302 to form the inner bond coat 304. The particles have a relatively fine average particle size so as to lead to a relatively dense layer (i.e., relatively low porosity). The plurality of particles can be first filtered through a mesh having a mesh rating of about 325 to about 400 such that greater than 90% of the particles (e.g., greater than about 99%) have an average diameter that is less than about 45 µm. For example, greater than 90% of the particles (e.g., greater than about 99%) can have an average diameter that is less than about 44 µm (for a 325 mesh size) or less than about 37 mm (for a 400 mesh size).

In the embodiment shown, the inner bond coat 304 defines the surface 305 that is substantially smooth, since the bonding between the inner bond coat 304 and the outer bond coat (or intermediate bond coat, if present) is chemical bonding (e.g., diffusion bonding). For example, the surface 305 can have a surface roughness of about 1. 5 µm Ra to about 7.5 µm Ra (e.g., about 1.75 µm Ra to about 5.25 µm Ra), where Ra is the arithmetic mean of displacement values as calculated to quantify the degree of roughness achieved.

The thickness of the inner bond coat 304 can vary depending on the component and operational environment. The inner bond coat 304 has an average thickness (Tisc) that of 200 µm to about 350 µm, as measured taking the average of the shortest distance from the base of the inner bond coat 304 (shown in the embodiment of FIG. 3 as the surface 303 of the substrate 302) to the surface 305 of the inner bond coat 304 at multiple points across the inner bond coat 304.

The outer bond coat 306 is substantially free from cobalt. As used herein, the term "substantially free" means no more than an insignificant trace amount present and encompasses completely free; 0 weight % up to 0.5 weight %.

The outer bond coat 306 is a NiCrAlY coating, such as a NiCrAlY coating having a composition of (by weight) about 21.0% to about 23.0% chromium, about 9% to about 11% aluminum, 0.05% to about 1.20% yttrium, 0% to about 0.01% phosphorous, 0% to about 0.01% nitrogen, 0% to about 0.040% oxygen, and the balance nickel. In particular embodiments, other reactive elements can be included in addition to, or instead of, yttrium. For example, the outer bond coat 306 may include, in combination with a NiCrAlY compound, compounds including materials of NiCrAlZr, NiCrAlHfSi, NiCrAlYZr, NiCrAlReY, or combinations thereof. The inclusion of such material may help adhesion of the scale to the bond coat, therefore improving the TBC life.

In one embodiment, the outer bond coat 306 defines an oxide surface layer (scale) 307 to which the ceramic coat 308 mechanically bonds the outer bond coat 306 texturized surface 307 that includes a plurality of peaks and valleys to aid in the bonding of the diffusion coating 308 thereon. For example, the surface 307 can have a surface roughness of about 8.5 µm Ra to about 20 µm Ra (e.g., about 9 µm Ra to about 15 µm Ra).

The thickness of the outer bond coat 306 can vary depending on the component and operational environment. The outer bond coat 306 has an average thickness (T_{OBC}) of 100 µm to about 400 µm, as measured taking the average of the shortest distance from the base of the outer bond coat 306 (shown in the embodiment of FIG. 3 as the surface 305 of the inner bond coat 304) to the surface 307 of the outer bond coat 306 at multiple points across the outer bond coat 306.

The outer bond coat 306 is formed via high velocity oxy-fuel coating spraying a plurality of particles onto the surface 305 of the inner bond coat 304 to form the outer bond coat 306. The particles have a relatively course average particle size so as to lead to a layer having a relatively high porosity. For example, the plurality of particles can be first filtered through a mesh having a mesh rating of about 100 to about 270 such that greater than 90% of the particles (e.g., greater than about 99%) have an average diameter that is about 50 µm to about 150 µm. For example, greater than 90% of the particles (e.g., greater than about 99%) can have an average diameter that is about 53 µm (for a 270 mesh size) to about 149 µm (for a 100 mesh size).

The inner bond coat 304 and the outer bond coat 306 are also different with respect to their respective sulfur diffusion rates. The inner bond coat 304 has a sulfur diffusion rate that is slower than the sulfur diffusion rate of the outer bond coat 306. In one embodiment, the inner bond coat 304 has a sulfur diffusion rate that is at least 10 times slower (e.g., about 50 times slower or more, such as about 100 times slower or more) than the sulfur diffusion rate of the outer bond coat 306.

The ceramic coat 308 may include, in one embodiment, a low thermal conductivity ceramic. For example, the low thermal conductivity ceramic may have a thermal conductivity of about 0.1 to 1.0 BTU/ft hr ° F., preferably in the range of 0.3 to 0.6 BTU/ft hr ° F. In one embodiment, the ceramic coat 308 may include a mixture of zirconiun oxide, yttrium oxide, ytterbium oxide and nyodenium oxide. In another embodiment, the ceramic coat 308 may include an yttria-stabilized zirconia (YSZ). In one embodiment, the ceramic coat 308 may be an YSZ having a composition of about 3 to about 10 weight percent yttria. In another embodiment, the ceramic coat 308 may be another ceramic material, such as yttria, nonstablilized zirconia, or zirconia stabilized by other oxides, such as magnesia (MgO), ceria (CeO₂), scandia (Sc₂O₃) or alumina (Al₂O₃). In yet other embodiments, the ceramic coat 308 may include one or more rare earth oxides such as, but not limited to, ytterbia, scandia, lanthanum oxide, neodymia, erbia and combinations thereof. In these yet other embodiments, the rare earth oxides may replace a portion or all of the yttria in the stabilized zirconia system. The ceramic coat 308 is deposited to a thickness that is sufficient to provide the required thermal protection for the underlying substrate 302, generally on the order of from about 75 µm to about 350 µm.

Any suitable deposition method for forming the ceramic coat 308 can be used, including but not limited to physical vapor deposition (PVD) techniques, chemical vapor deposition techniques, low pressure plasma spray (LPPS) techniques, air plasma spray (APS), etc.

Although shown as being directly on the adjacent layer (i.e., with no intermediate layer present therebetween), another layer or layers can be present within the TBC system 310 in particular embodiments. For example, additional bond coats can be present in the TBC system 310.

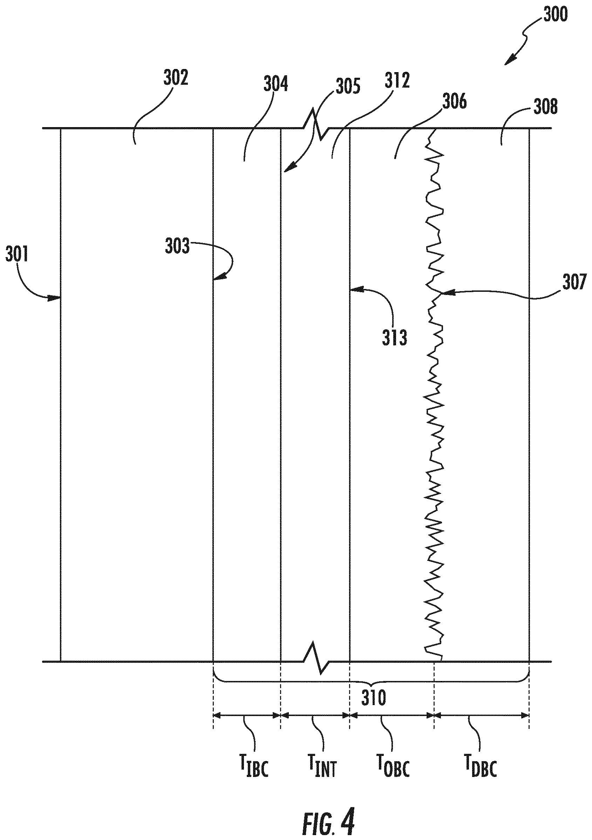

Fig. 4 shows another TBC system 310 that includes an intermediate bond coat 312 positioned between the inner bond coat 304 and the outer bond coat 306. The intermediate bond coat 312 has a porosity that is greater than the porosity of the inner bond coat 304 (i.e., the inner bond coat 304 is more dense than the intermediate bond coat 312). Also, the intermediate bond coat 312 has a porosity that is less than the porosity of the outer bond coat 306 (i.e., the intermediate bond coat 312 is more dense than the outer bond coat 306).

The inner bond coat 304 contains CoNiCrAlY, while the intermediate bond coat 312 and the outer bond coat 306 are substantially free from cobalt. The intermediate bond coat 312 and the outer bond coat 306 can be made from the same composition or a different composition. For example, the intermediate bond coat 312 may be a metal, metallic, intermetallic, metal alloy, composite and combinations thereof. In one embodiment, the intermediate bond coat 312 may be a NiAl, such as a predominantly beta NiAl phase, with limited alloying additions as described above with reference to the outer bond coat 306. However, the composition of the intermediate bond coat 312 is not limited to NiAl bond coats, and may be any metallic coating with an appropriate bonding and temperature capability. For example, the intermediate bond coat 312 may be a NiCrAlY coating. In one embodiment, the intermediate bond coat 312 can include NiCrAlY, and the outer bond coat 306 can include NiCrAl.

The porosity of the inner bond coat 304, the intermediate bond coat 312, and the outer bond coat 306 are different, with the coatings being more dense closer to the substrate 302. Thus, the inner bond coat 304 is a dense layer compared to the intermediate bond coat 312 and the outer bond coat 306. That is, the inner bond coat 304 has a porosity that is less than the porosity of the intermediate bond coat 312 and the porosity of the outer bond coat 306. In contrast, the outer bond coat 306 is generally a porous layer compared to the intermediate bond coat 312 and the inner bond coat 304. That is, the outer bond coat 306 has a porosity that is greater than the porosity of the intermediate bond coat 312 and the porosity of the inner bond coat 304. As such, the intermediate bond coat 312 has, in one embodiment, a porosity that is greater than the porosity of the inner bond coat 304, and the intermediate bond coat 312 has a porosity that is less than the porosity of the outer bond coat 306. The inner bond coat 304 has a porosity that is 0.5% to 5 %; the intermediate bond coat 312 can have a porosity that is about 4% to about 6%; and the outer bond coat 306 can have a porosity that is 5 % to 25 %.

The intermediate bond coat 312 has, in one embodiment, an average thickness (T_{INT}) that is about 100 µm to about 400 µm, as measured taking the average of the shortest distance from the base of the intermediate bond coat 312 (shown in the embodiment of FIG. 4 as the surface 305 of the inner bond coat 304) to the surface 313 of the intermediate bond coat 313 at multiple points across the intermediate bond coat 312.

In the embodiment of FIG. 4, the intermediate bond coat 312 defines the surface 313 that is substantially smooth, since the bonding between the intermediate bond coat 312 and the outer bond coat is chemical bonding (e.g., diffusion bonding). For example, the surface 313 can have a surface roughness of about 1. 5 µm Ra to about 7.5 µm Ra (e.g., about 1.75 µm Ra to about 5.25 µm Ra).

The intermediate bond coat 312 can be formed via any suitable deposition process, including air plasma spraying (APS), high velocity oxy-fuel coating spraying (HVOF), a wire arc spraying, a low pressure plasma spray (LPPS) process, etc. In one embodiment, the intermediate bond coat 312 is formed via high velocity oxy-fuel coating spraying a plurality of particles onto the surface 305 of the inner bond coat 304 to form the intermediate bond coat 312. The particles have an average particle size that is larger than the particles utilized to form the inner bond coat 304 but smaller than the particles used to form the outer bond coat 306. As such, the intermediate bond coat 312 has a relative porosity that is between the relatively dense inner bond coat 304 and the relatively porous outer bond coat 306.

The TBC systems 310 described above are particularly suitable for use on a metallic engine component within the combustor assembly 100 of FIG. 2, such as inner dome 116, outer dome 118, including the inner cowl 130 and outer cowl 126, respectively, the heat shields 142, etc. However, the TBC systems 310 can be utilized on any suitable component within the gas turbine engine 10.

A method is provided for repairing an existing TBC on a substrate. After a period of use, an engine component is subjected to hot combustion gases during operation of the engine. Thus, a TBC on the surface of the component is subjected to severe attack from the hostile environment, and can become damaged through oxidation, corrosion, erosion, cracking, rub events, etc.

The method can be utilized on any TBC deposited on the surface of the substrate, particularly including those TBCs having a bond coat (e.g., a single layer bond coat or a double layer bond coat as described in the present application) and a ceramic coat. The method can be utilized to repair a TBC on an entire surface of a substrate, or a localized portion of a TBC on a surface of a substrate.

According to the method of the invention, any existing ceramic coating (or other diffusion barrier layer) is removed from an area to be repaired on the surface of a substrate. As stated, the area to be repaired can be the entire surface of the substrate or a localized portion of the surface. While various techniques can be used to remove the any existing ceramic coating on the surface, one particularly suitable method for removing the existing layer(s) is to grit blast the exposed surface, such as by a technique known as pencil grit blasting.

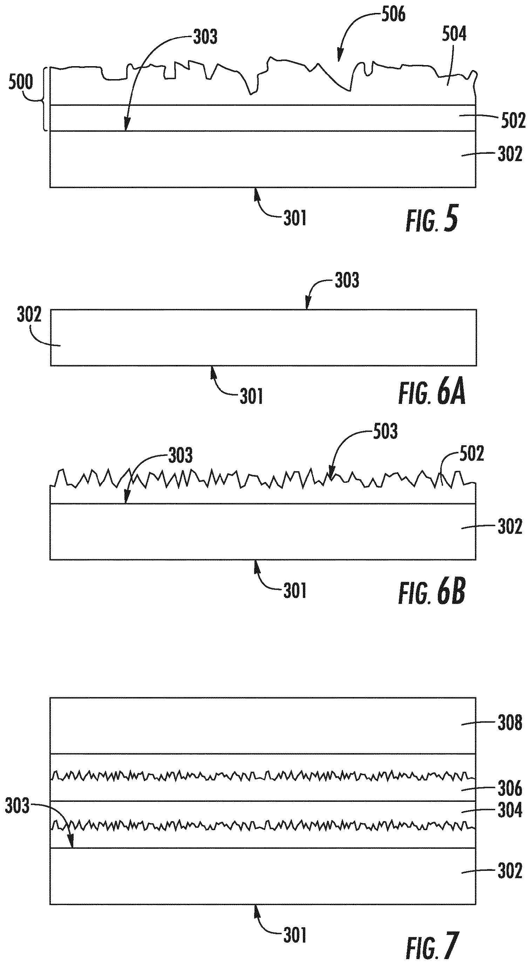

FIG. 5 shows a substrate 302 with a damaged TBC 500 across the surface 303 of the substrate 302. The damaged TBC 500 includes a bonding layer 502 and a ceramic layer 504 that defines an exposed surface 506 of the TBC 500. As shown, the bonding layer 502 is on the hot surface 303 of the substrate 302 and is positioned between the substrate 302 and the ceramic layer 504.

FIG. 6A shows the substrate 302 of FIG. 5 after removing all of the damaged TBC 500 to expose the entire surface 303. That is, the entire ceramic layer 504 and substantially all of the bonding layer 502 has been removed to expose the surface 303 of the substrate across the entire component. Then, an inner bond coat 304, an optional intermediate bond coat 312, and a ceramic layer 312 can be formed on the surface 303, as discussed above with respect to FIGs. 3 and 4.

FIG. 6B shows the substrate 302 of FIG. 5 after removing all of the damaged ceramic layer 504 TBC 500 and a portion of the bond layer 502 to expose a bond surface 503 across the entire surface 303 of the substrate 302. That is, the entire ceramic layer 504 and a portion of the bonding layer 502 have been removed, while leaving a portion of the bonding layer 502 across the surface 303 of the substrate 302. The surface 503 formed on the bonding layer 502 is shown as a substantially rough surface, so as to help adhesion between the bonding layer 502 and the subsequently formed layers formed thereon (e.g., the inner bond coat 304). An inner bond coat 304, an optional intermediate bond coat 312, an outer bond coat 306, and a ceramic layer 312 can be formed on the surface 503 of the remaining bonding layer 502, as discussed above with respect to FIGs. 3 and 4. For example, FIG. 7 shows the substrate 302 of FIG. 6B after formation of an inner bond coat 304, an outer bond coat 306, and a ceramic layer 312 formed on the surface 503 of the remaining bonding layer 502.

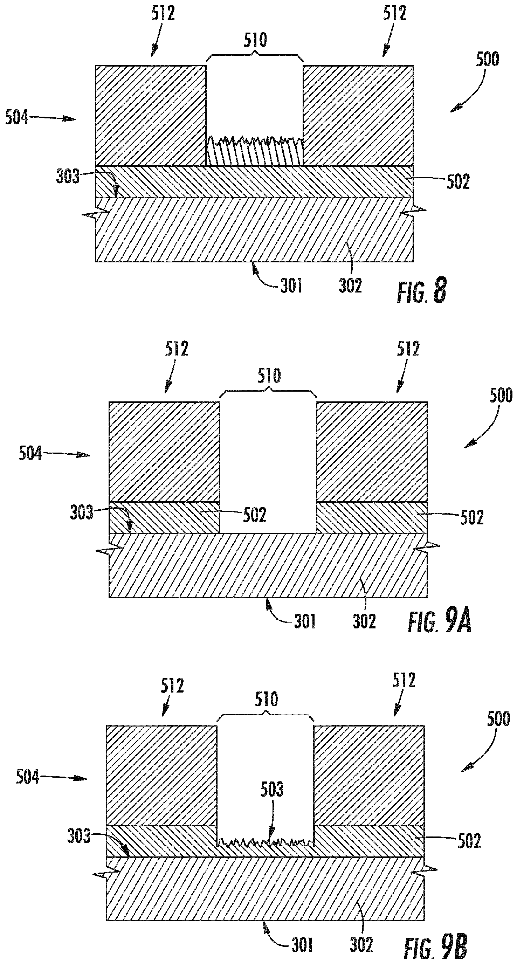

FIG. 8 shows a substrate 302 with a damaged TBC 500 across a first portion 510 the surface 303 of the substrate 302, with a second portion 512 of the TBC 500 being undamaged. According to one embodiment not part of claimed invention, the ceramic layer 504 can be removed locally from the damaged portion 510 of the TBC while leaving the undamaged portion 512 of the ceramic layer 504. For example, the repair method can remove oxides and any residual fragments of the ceramic layer 504 and at least a portion of the inner bonding layer 502, but only in the damaged portion 510. While various techniques can be used, a preferred method is to grit blast the exposed surface of the TBC 504 in the damaged portion 512, such as by a technique known as pencil grit blasting. This method allows for is selective removal of the TBC 504 in the damaged portion 512 to ensure that the remaining ceramic layer 504 in the undamaged portion 512 is not subjected to the procedure. In certain embodiments, it may be desirable to mask the surrounding ceramic layer 504 in the undamaged portions 512 with, for example, tape masking, during the grit blasting operation. In addition to providing a level of protection to the ceramic layer 504 in the undamaged portions 512, tape masking would also serve as a proof test for the integrity of the ceramic layer 504 in the undamaged portions 512 immediately surrounding the damaged portions 510.

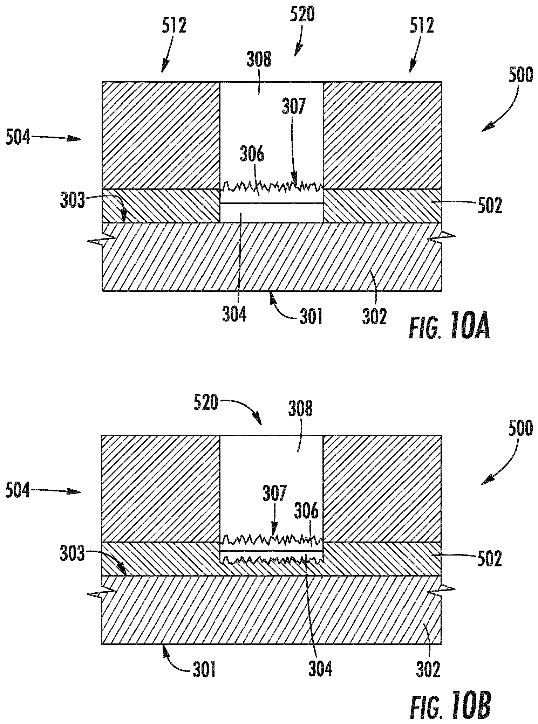

FIG. 9A shows the substrate 302 of FIG. 8 after removing all of the damaged portion 510 of the TBC 500 to expose the underlying surface 303, while leaving the undamaged portion 512 of the TBC 500. That is, the ceramic layer 504 and substantially all of the bonding layer 502 has been removed to expose the surface 303 in the damaged portion 510. Then, an inner bond coat 304, an optional intermediate bond coat 312, and a ceramic layer 312 can be formed on the surface 303, as discussed above with respect to FIGs. 3 and 4. Fig. 10A shows the substrate 302 of FIG. 9A after formation of an inner bond coat 304, an outer bond coat 306, and a ceramic layer 312 formed on the surface 303 of the substrate 302 to define a repaired area 520 corresponding to the damaged area 510 of FIGs. 8 and 9A.

FIG. 9B shows the substrate 302 of FIG. 8 after removing all of the damaged portion 510 of the TBC 500 and a portion of the bond layer 502 to expose a bond surface 503, while leaving the undamaged portion 512 of the TBC 500. That is, the ceramic layer 504 and a portion of the bonding layer 502 has been removed, while leaving a portion of the bonding layer 502 within the damaged area 510. The surface 503 formed on the bonding layer 502 is shown as a substantially rough surface, so as to help adhesion between the bonding layer 502 and the subsequently formed layers formed thereon (e.g., the inner bond coat 304). Then, an inner bond coat 304, an optional intermediate bond coat 312, an outer bond coat 306, and a ceramic layer 312 can be formed on the surface remaining bonding layer 502 within the damaged area 510, as discussed above with respect to FIGs. 3 and 4. Fig. 10B shows the substrate 302 of FIG. 10A after formation of an inner bond coat 304, an outer bond coat 306, and a ceramic layer 312 formed on the remaining bonding layer 502 to define a repaired area 520 corresponding to the damaged area 510 of FIGs. 8 and 9B.

This written description uses examples to disclose the invention, including the best mode, and also to enable any person skilled in the art to practice the invention, including making and using any devices or systems and performing any incorporated methods.

## Claims

1. A turbine engine component (300) having a repaired thermal barrier coating (520), the turbine engine component (300) comprising:
a substrate (302) defining a surface (303);
a thermal barrier coating (500) on a first portion (512) of the surface (303) of the substrate (302), wherein the thermal barrier coating (500) comprises an inner bonding layer (502) and a first ceramic layer (504), and wherein the inner bonding layer (502) is positioned between the substrate (302) and the first ceramic layer (504);
a repaired thermal barrier coating (308) on a second portion (510) of the surface (303) of the substrate (302), **characterised in that** the repaired thermal barrier coating (308) comprises:
an inner bond coat (304) on the surface (303) of the substrate (302), wherein the inner bond coat (304) comprises a cobalt-containing material, wherein the inner bond coat comprises a CoNiCrAlY alloy having a composition in weight % of 31.0% to 33.5% nickel, 21.0% to 23.0% chromium, 9.5% to 10.5% aluminum, 0.05% to 0.50% yttrium, 0% to 0.01% phosphorous, 0% to 0.01% nitrogen, 0% to 0.040% oxygen, and the balance cobalt;
an outer bond coat (306) on the inner bond coat (304), wherein the outer bond coat (306) is substantially free from cobalt, wherein substantially free from cobalt means no more than 0.5 wt% and encompasses completely free from cobalt, wherein the outer bond coat comprises a NiCrAlY coating having a composition in weight % of 21.0% to 23.0% chromium, 9% to 11% aluminum, 0.05% to 1.20% yttrium, 0% to 0.01% phosphorous, 0% to 0.01% nitrogen, 0% to 0.040% oxygen, and the balance nickel; and
a ceramic coat (308) on the outer bond coat (306),
wherein the inner bond coat (304) has a porosity that is less than the porosity of the outer bond coat (306), wherein the inner bond coat (304) has a porosity that is 0.5% to 5%, and wherein the outer bond coat (306) has a porosity that is 5% to 25%;
wherein the inner bond coat (304) has an average thickness of 200 µm to 350 µm, and wherein the outer bond coat (306) has an average thickness of 100 µm to 400 µm.

2. The turbine engine component (500) as in claim 1, wherein the repaired thermal barrier coating (308) further comprises:
an inner bonding layer (502) positioned between the surface (303) of the substrate (302) and the inner bond coat (304).

3. The turbine engine component (500) as in claim 1 or claim 2 wherein the inner bond coat (304) has a sulfur diffusion rate that is at least 10 times slower than the sulfur diffusion rate of the outer bond coat (306).

4. The turbine engine component (500) as in claim 1, further comprising:
an intermediate bond coat (312) positioned between the outer bond coat (306) and the ceramic coat (308), and wherein the intermediate bond coat (312) has a porosity that is greater than a porosity of the inner bond coat (304), and further wherein the intermediate bond coat (312) has a porosity that is less than a porosity of the outer bond coat (306).

5. A method of repairing a thermal barrier coating (500) on a turbine engine component (300), the method comprising:
removing any ceramic coating (504) from an area of a surface (303) of a substrate (302), wherein removing any ceramic coating (504) from the surface (303) of the substrate (302) comprises removing all material from the surface (303) of the substrate (302) to expose the surface of the substrate (302);
forming an inner bond coat (304) over the area of the surface (303) of the substrate (302), wherein the inner bond coat (304) comprises a cobalt-containing material;
forming an outer bond coat (306) over the inner bond coat (304), wherein the outer bond coat (306) is substantially free from cobalt, wherein substantially free from cobalt means no more than 0.5 wt% and encompasses completely free from cobalt,
wherein the inner bond coat (304) has a porosity that is 0.5% to 5%, and wherein the outer bond coat (306) has a porosity that is 5% to 25%; and
forming a ceramic coat (308) on the outer bond coat (306);
**characterised in that** the forming the inner bond coat (304) is made by high velocity oxy-fuel coating spraying a plurality of first particles onto the area of the substrate (302) to form an inner bond coat (304), wherein the plurality of first particles comprises a cobalt-containing material and have an average particle size that is less than about 45 µm, wherein the plurality of first particles comprises a CoNiCrAlY alloy having a composition in weight % of 31.0% to 33.5% nickel, 21.0% to 23.0% chromium, 9.5% to 10.5% aluminum, 0.05% to 0.50% yttrium, 0% to 0.01% phosphorous, 0% to 0.01% nitrogen, 0% to 0.040% oxygen, and the balance cobalt; and
wherein the outer bond coat (306) is formed via high velocity oxy-fuel coating spraying a plurality of second particles having an average diameter that is 50 µm to 150 µm, and wherein the plurality of second particles comprises NiCrAlY, wherein NiCrAlY has a composition in weight % of 21.0% to 23.0% chromium, 9% to 11% aluminum, 0.05% to 1.20% yttrium, 0% to 0.01% phosphorous, 0% to 0.01% nitrogen, 0% to 0.040% oxygen, and the balance nickel.

6. The method (500) as in claim 5, further comprising:
prior to forming the outer bond coat (306), forming an intermediate bond coat (312) on the inner bond coat (304), wherein the intermediate bond coat (312) is substantially free from cobalt, and wherein the intermediate bond coat (312) has a porosity that is greater than a porosity of the inner bond coat (304), and further wherein the intermediate bond coat (312) has a porosity that is less than a porosity of the outer bond coat (306).

## Patentansprüche

1. Turbinenmotorkomponente (300), die eine reparierte Wärmedämmbeschichtung (520) aufweist, die Turbinenmotorkomponente (300) umfassend:
ein Substrat (302), das eine Oberfläche (303) definiert;
eine Wärmedämmbeschichtung (500) auf einem ersten Abschnitt (512) der Oberfläche (303) des Substrats (302), wobei die Wärmedämmbeschichtung (500) eine innere Bindungsschicht (502) und eine erste Keramiklage (504) umfasst und wobei die innere Bindungsschicht (502) zwischen dem Substrat (302) und der ersten Keramiklage (504) positioniert ist;
eine reparierte Wärmedämmbeschichtung (308) auf einem zweiten Abschnitt (510) der Oberfläche (303) des Substrats (302),
**dadurch gekennzeichnet, dass** die reparierte Wärmedämmbeschichtung (308) umfasst:
eine innere Bindungsschicht (304) auf der Oberfläche (303) des Substrats (302), wobei die innere Bindungsschicht (304) ein kobalthaltiges Material umfasst, wobei die innere Bindungsschicht eine CoNiCrAlY-Legierung umfasst, die eine Zusammensetzung in Gew.-% von 31,0 % bis 33,5 % Nickel, 21,0 % bis 23,0 % Chrom, 9,5 % bis 10,5 % Aluminium, 0,05 % bis 0,50 % Yttrium, 0 % bis 0,01 % Phosphor, 0 % bis 0,01 % Stickstoff, 0 % bis 0,040 % Sauerstoff, und den Rest Kobalt aufweist;
eine äußere Bindungsschicht (306) auf der inneren Bindungsschicht (304), wobei die äußere Bindungsschicht (306) im Wesentlichen frei von Kobalt ist, wobei im Wesentlichen frei von Kobalt nicht mehr als 0,5 Gew.-% bedeutet und vollständig frei von Kobalt umschließt, wobei die äußere Bindungsschicht eine NiCrAlY-Beschichtung umfasst, die eine Zusammensetzung in Gew.-% von 21,0 % bis 23,0 % Chrom, 9 % bis11 % Aluminium, 0,05 % bis 1,20 % Yttrium, 0 % bis 0,01 % Phosphor, 0 % bis 0,01 % Stickstoff, 0 % bis 0,040 % Sauerstoff und den Rest Nickel aufweist; und
eine Keramikschicht (308) auf der äußeren Bindungsschicht (306),
wobei die innere Bindungsschicht (304) eine Porosität aufweist, die geringer ist als die Porosität der äußeren Bindungsschicht (306), wobei die innere Bindungsschicht (304) eine Porosität aufweist, die 0,5 % bis 5 % beträgt, und wobei die äußere Bindungsschicht (306) eine Porosität aufweist, die 5 % bis 25 % beträgt;
wobei die innere Bindungsschicht (304) eine durchschnittliche Dicke von 200 µm bis 350 µm aufweist, und wobei die äußere Bindungsschicht (306) eine durchschnittliche Dicke von 100 µm bis 400 µm aufweist.

2. Turbinenmotorkomponente (500) nach Anspruch 1, wobei die reparierte Wärmedämmbeschichtung (308) ferner umfasst:
eine innere Bindungslage (502), die zwischen der Oberfläche (303) des Substrats (302) und der inneren Bindungsschicht (304) positioniert ist.

3. Turbinenmotorkomponente (500) nach Anspruch 1 oder 2, wobei die innere Bindungsschicht (304) eine Schwefeldiffusionsrate aufweist, die mindestens 10-mal langsamer ist als die Schwefeldiffusionsrate der äußeren Bindungsschicht (306).

4. Turbinenmotorkomponente (500) nach Anspruch 1, ferner umfassend:
eine Zwischenbindungsschicht (312), die zwischen der äußeren Bindungsschicht (306) und der Keramikschicht (308) positioniert ist und wobei die Zwischenbindungsschicht (312) eine Porosität aufweist, die größer ist als die Porosität der inneren Bindungsschicht (304), und ferner wobei die Zwischenbindungsschicht (312) eine Porosität aufweist, die kleiner ist als die Porosität der äußeren Bindungsschicht (306).

5. Verfahren zum Reparieren einer Wärmedämmbeschichtung (500) auf einer Turbinenmotorkomponente (300), das Verfahren umfassend:
Entfernen einer beliebigen keramischen Beschichtung (504) von einem Bereich einer Oberfläche (303) eines Substrats (302), wobei das Entfernen einer keramischen Beschichtung (504) von der Oberfläche (303) des Substrats (302) das Entfernen des gesamten Materials von der Oberfläche (303) des Substrats (302) umfasst, um die Oberfläche des Substrats (302) freizulegen;
Ausbilden einer inneren Bindungsschicht (304) über dem Bereich der Oberfläche (303) des Substrats (302), wobei die innere Bindungsschicht (304) ein kobalthaltiges Material umfasst;
Ausbilden einer äußeren Bindungsschicht (306) über der inneren Bindungsschicht (304), wobei die äußere Bindungsschicht (306) im Wesentlichen frei von Kobalt ist, wobei im Wesentlichen frei von Kobalt nicht mehr als 0,5 Gew.-% bedeutet und vollständig frei von Kobalt umschließt,
wobei die innere Bindungsschicht (304) eine Porosität aufweist, die 0,5 % bis 5 % beträgt, und wobei die äußere Bindungsschicht (306) eine Porosität aufweist, die 5 % bis 25 % beträgt; und
Ausbilden einer Keramikschicht (308) auf der äußeren Bindungsschicht (306);
**dadurch gekennzeichnet, dass** das Ausbilden der inneren Bindungsschicht (304) durch Hochgeschwindigkeitsflammspritzen erfolgt, wobei eine Vielzahl erster Partikel auf den Bereich des Substrats (302) gesprüht wird, um eine innere Bindungsschicht (304) auszubilden, wobei die Vielzahl erster Partikel ein kobalthaltiges Material umfasst und eine durchschnittliche Partikelgröße aufweist, die weniger als etwa 45 µm beträgt, wobei die Vielzahl erster Partikel eine CoNiCrAlY-Legierung umfasst, die eine Zusammensetzung in Gew.% von 31,0 % bis 33,5 % Nickel, 21,0 % bis 23,0 % Chrom, 9,5 % bis 10,5 % Aluminium, 0,05 % bis 0,50 % Yttrium, 0 % bis 0,01 % Phosphor, 0 % bis 0,01 % Stickstoff, 0 % bis 0,040 % Sauerstoff und den Rest Kobalt aufweist; und
wobei die äußere Bindungsschicht (306) durch Hochgeschwindigkeitsflammspritzen ausgebildet wird, wobei eine Vielzahl zweiter Partikel, die einen durchschnittlichen Durchmesser von 50 µm bis 150 µm aufweist, gesprüht wird, und wobei die Vielzahl zweiter Partikel NiCrAlY umfasst, wobei NiCrAlY eine Zusammensetzung in Gew.-% von 21,0 % bis 23,0 % Chrom, 9 % bis 11 % Aluminium, 0,05 % bis 1,20 % Yttrium, 0 % bis 0,01 % Phosphor, 0 % bis 0,01 % Stickstoff, 0 % bis 0,040 % Sauerstoff und den Rest Nickel aufweist.

6. Verfahren (500) nach Anspruch 5, ferner umfassend:
vor dem Ausbilden der äußeren Bindungsschicht (306), Ausbilden einer Zwischenbindungsschicht (312) auf der inneren Bindungsschicht (304), wobei die Zwischenbindungsschicht (312) im Wesentlichen frei von Kobalt ist und wobei Zwischenbindungsschicht (312) eine Porosität aufweist, die größer ist als eine Porosität der inneren Bindungsschicht (304), und ferner wobei die Zwischenbindungsschicht (312) eine Porosität aufweist, die kleiner ist als eine Porosität der äußeren Bindungsschicht (306).

## Revendications

1. Composant de moteur à turbine (300) présentant un revêtement de barrière thermique réparé (520), le composant de moteur à turbine (300) comprenant :
un substrat (302) définissant une surface (303) ;
un revêtement de barrière thermique (500) sur une première partie (512) de la surface (303) du substrat (302), dans lequel le revêtement de barrière thermique (500) comprend une couche de liaison interne (502) et une première couche céramique (504), et dans lequel la couche de liaison interne (502) est positionnée entre le substrat (302) et la première couche céramique (504) ;
un revêtement de barrière thermique réparé (308) sur une seconde partie (510) de la surface (303) du substrat (302), **caractérisé en ce que** le revêtement de barrière thermique réparé (308) comprend :
un feuil de liaison chimique interne (304) sur la surface (303) du substrat (302), dans lequel le feuil de liaison chimique interne (304) comprend un matériau contenant du cobalt, dans lequel le feuil de liaison chimique interne comprend un alliage CoNiCrAlY présentant une composition en pourcentage en poids de 31,0 % à 33,5 % de nickel, de 21,0 % à 23,0 % de chrome, de 9,5 % à 10,5 % d'aluminium, de 0,05 % à 0,50 % d'yttrium, de 0 % à 0,01 % de phosphore, de 0 % à 0,01 % d'azote, de 0 % à 0,040 % d'oxygène, et le complément en cobalt ;
un feuil de liaison chimique externe (306) sur le feuil de liaison chimique interne (304), dans lequel le feuil de liaison chimique externe (306) est essentiellement exempt de cobalt, dans lequel essentiellement exempt de cobalt signifie pas plus de 0,5 % en poids et englobe l'absence totale de cobalt, dans lequel le feuil de liaison chimique externe comprend un revêtement NiCrAlY présentant une composition en pourcentage en poids de 21,0 % à 23,0 % de chrome, de 9 % à 11 % d'aluminium, de 0,05 % à 1,20 % d'yttrium, de 0 % à 0,01 % de phosphore, de 0 % à 0,01 % d'azote, de 0 % à 0,040 % d'oxygène, et le complément en nickel ; et
Un feuil céramique (308) sur le feuil de liaison chimique externe (306),
dans lequel le feuil de liaison chimique interne (304) présente une porosité qui est inférieure à la porosité du feuil de liaison chimique externe (306), dans lequel le feuil de liaison chimique interne (304) présente une porosité comprise entre 0,5 % et 5 %, et dans lequel le feuil de liaison chimique externe (306) présente une porosité comprise entre 5 % et 25 % ;
dans lequel le feuil de liaison interne (304) présente une épaisseur moyenne de 200 µm à 350 µm, et dans lequel le feuil de liaison externe (306) présente une épaisseur moyenne de 100 µm à 400 µm.

2. Composant de moteur à turbine (500) selon la revendication 1, dans lequel le revêtement de barrière thermique réparé (308) comprend en outre :
une couche de liaison interne (502) positionnée entre la surface (303) du substrat (302) et le feuil de liaison chimique interne (304).

3. Composant de moteur à turbine (500) selon la revendication 1 ou la revendication 2, dans lequel le feuil de liaison chimique interne (304) présente une vitesse de diffusion de soufre qui est au moins 10 fois plus lente que la vitesse de diffusion de soufre du feuil de liaison chimique externe (306).

4. Composant de moteur à turbine (500) selon la revendication 1, comprenant en outre :
un feuil de liaison chimique intermédiaire (312) positionné entre le feuil de liaison chimique externe (306) et le feuil céramique (308), et dans lequel le feuil de liaison chimique intermédiaire (312) présente une porosité qui est supérieure à une porosité du feuil de liaison chimique interne (304), et dans lequel en outre le feuil de liaison chimique intermédiaire (312) présente une porosité qui est inférieure à une porosité du feuil de liaison chimique externe (306).

5. Procédé de réparation d'un revêtement de barrière thermique (500) sur un composant de moteur à turbine (300), le procédé comprenant :
le retrait de tout revêtement céramique (504) d'une zone d'une surface (303) d'un substrat (302), dans lequel le retrait de tout revêtement céramique (504) de la surface (303) du substrat (302) comprend le retrait de tout matériau de la surface (303) du substrat (302) pour exposer la surface du substrat (302) ;
la formation d'un feuil de liaison chimique interne (304) sur la zone de la surface (303) du substrat (302), dans lequel le feuil de liaison chimique interne (304) comprend un matériau contenant du cobalt ;
la formation d'un feuil de liaison externe (306) sur le feuil de liaison interne (304), dans lequel le feuil de liaison externe (306) est essentiellement exempt de cobalt, dans lequel essentiellement exempt de cobalt signifie pas plus de 0,5 % en poids et englobe complètement sans cobalt,
dans lequel le feuil de liaison interne (304) a une porosité qui est de 0,5 % à 5 %, et dans lequel le feuil de liaison externe (306) a une porosité qui va de 5 % à 25 % ; et
la formation d'un feuil céramique (308) sur le feuil de liaison chimique externe (306) ;
**caractérisé en ce que** la formation du feuil de liaison chimique interne (304) est constituée par un revêtement oxy-combustible à grande vitesse pulvérisant une pluralité de premières particules sur la zone du substrat (302) pour former un feuil de liaison chimique interne (304), dans lequel la pluralité de premières particules comprend un matériau contenant du cobalt et présente une taille moyenne de particules qui est inférieure à 45 µm, dans lequel la pluralité de premières particules comprend un alliage CoNiCrAlY présentant une composition en pourcentage en poids de 31,0 % à 33,5 % de nickel, de 21,0 % à 23,0 % de chrome, de 9,5 % à 10,5 % d'aluminium, de 0,05 % à 0,50 % d'yttrium, de 0 % à 0,01 % de phosphore, de 0 % à 0,01 % d'azote, de 0 % à 0,040 % d'oxygène, et le complément en cobalt ; et
dans lequel le feuil de liaison chimique externe (306) est formé par l'intermédiaire d'un revêtement oxy-combustible à grande vitesse pulvérisant une pluralité de secondes particules présentant un diamètre moyen compris entre 50 µm et 150 µm, et dans lequel la pluralité de secondes particules comprend NiCrAlY, dans lequel NiCrAlY présente une composition en pourcentage en poids de 21,0 % à 23,0 % de chrome, de 9 % à 11 % d'aluminium, de 0,05 % à 1,20 % d'yttrium, de 0 % à 0,01 % de phosphore, de 0 % à 0,01 % d'azote, de 0 % à 0,040 % d'oxygène, et le complément en nickel.

6. Procédé (500) selon la revendication 5, comprenant en outre :
avant la formation du feuil de liaison chimique externe (306), la formation d'un feuil de liaison chimique intermédiaire (312) sur le feuil de liaison chimique interne (304), dans lequel le feuil de liaison chimique intermédiaire (312) est essentiellement exempt de cobalt, et dans lequel le feuil de liaison chimique intermédiaire (312) présente une porosité qui est supérieure à une porosité du feuil de liaison chimique interne (304), et dans lequel en outre le feuil de liaison chimique intermédiaire (312) présente une porosité qui est inférieure à une porosité du feuil de liaison chimique externe (306).
